# EUROPEAN PATENT SPECIFICATION

(11) **EP 0 326 747 B1**
(45) Date of publication and mention of the grant of the patent: **03.08.1994**
(21) Application number: 88310497.8
(22) Date of filing: 08.11.1988
(51) Int. Cl.: H03J 7/18

(54) **Radio data system receiver**
Empfänger für RDS
Récepteur pour RDS

(30) Priority: 05.02.1988 JP 25403/88
(43) Date of publication of application: 09.08.1989
(73) Proprietor: PIONEER ELECTRONIC CORPORATION, Meguro-ku Tokyo 153 (JP)
(72) Inventor: Kasa, Kohichi c/o Pioneer Electronic Corporation, Oaza Yamada Kawagoe-shi Saitama (JP); Ichikawa, Toshihito Pioneer Electronic Corporation, Oaza Yamada Kawagoe-shi Saitama (JP); Nishida, Junichi c/oPioneer Electronic Corporation, Oaza Yamada Kawagoe-shi Saitama (JP)
(74) Representative: Brunner, Michael John

(56) References cited:
- EP-A- 0 224 763
- DE-A- 3 149 409
- IEEE TRANSACTIONS ON CONSUMER ELECTRONICS, vol. CE-33, no. 3, August 1987, pages 319-325, IEEE, New York, NY, US; K. TAURA et al.: "Automatic tuning car radio based on the radio data system"
- Specification of the Radio Data System RDS for VHF/FM sound broadcasting, Editor: Rudolf Gressmann, Technical Centre of the European Broadcasting Union, Bruxelles, 1984.

## Description

The present invention relates to a method of controlling a receiver for a radio data system broadcast (hereinafter referred to as an "RDS receiver").

In a radio data system broadcast, broadcasting-related information such as information on the contents of programs is transmitted, through multiplex modulated broadcasting of the program from a broadcasting station and demodulation on reception, to obtain data to enable a radio listener to choose a desired one of the programs on the basis of the broadcast data. In such systems, a wave of 57 kHz frequency, which is the third harmonic of a stereo pilot signal of 19 kHz is used as a subcarrier wave outside the frequency band of a frequency modulation wave and subjected to amplitude modulation by a data signal obtained by filtering and biphase coding, and indicates broadcasting-related information such as the information on the contents of the programs, so that a radio data signal is obtained through the amplitude modulation. The subcarrier wave is combined with a main carrier wave, by frequency modulation, for broadcasting.

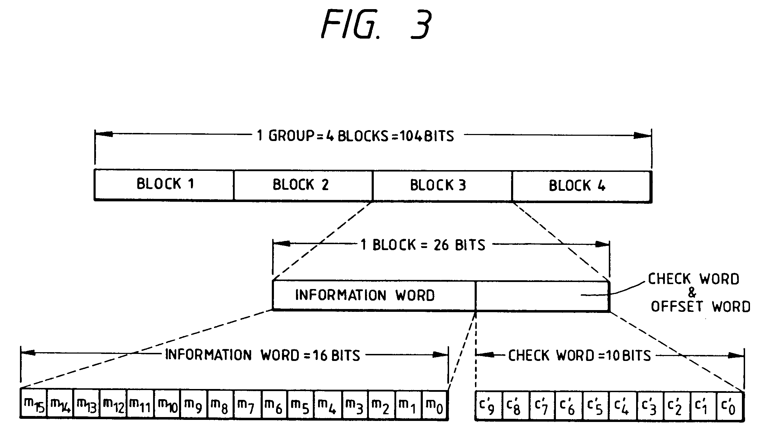

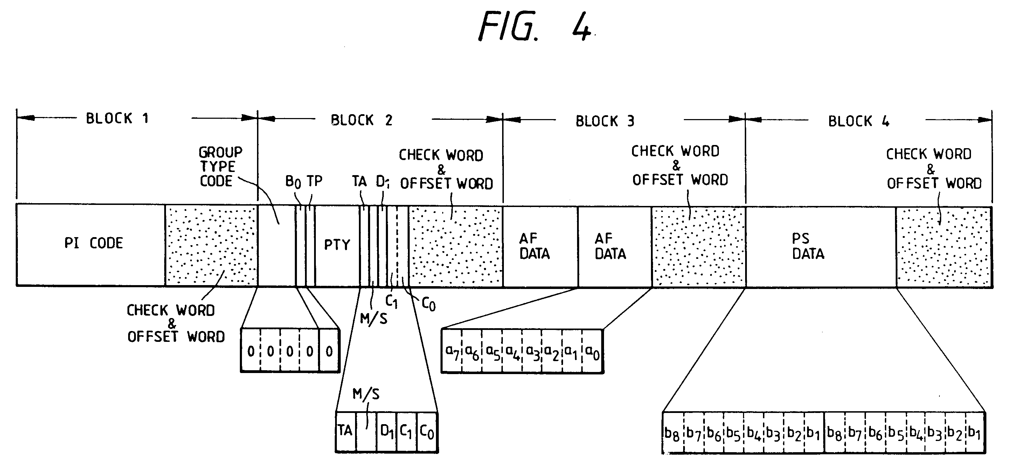

The radio data signal is subjected to repeated multiplex transmission as every 104 bits of the signal are handled as a group (as will be understood from FIG. 3 showing the base band coding structure of the radio data signal). The group comprises four blocks each consisting of 26 bits. Each of the blocks consists of a 16-bit information word and a 10-bit check word. As shown in FIG. 4, program identity code (PI code) is disposed in the first block 1, road traffic program recognition data (TP code) and road traffic announcement recognition code (TA code) is disposed in the second block 2, data (AF data) on the frequencies of broadcasting stations constituting the network of stations broadcasting the same program is disposed in the third block 3, and data (PS data) on a program service name such as the names of the broadcasting stations and that of the network is disposed in the fourth block 4. The groups are classified into sixteen types 0, 1, 2, 3, 4, 5, 6, 7, 8, 9, 10, 11, 12, 13, 14 and 15 by four bits, depending on the contents of the groups. Two versions A and B are defined for the types. The codes of the type and version of each group are disposed in the second block 2. The AF data are transmitted only in the group of the type 0 of the version A.

The PS data is transmitted in the group of the type 0 of the version A or the group of the type 0 of the version B. The TP code is disposed in the second block 2 of each group and is a 1-bit code indicating whether or not the broadcast signal carries road traffic information. If the TP code is "0" in logic, the broadcast signal does not carry the road traffic information. If the TP code is "1" in logic, the broadcast signal carries the road traffic information. The TA code is also a 1-bit code, which becomes "1" in logic at the beginning of the transmission of the road traffic information and becomes "0" in logic at the end of the transmission thereof. For these reasons, if it is made possible that the waiting state of only receiving the RDS broadcast signal carrying the TP code of "1" in logic, but not performing an audio output is established to enable interruption by the TA code to listen to the road traffic information, listening to music through a tape player being automatically changed to listening to the road traffic information, for example.

As for an RDS receiver mounted in a vehicle to receive an RDS signal, the state of reception of the wave is likely to deteriorate along with the movement of the vehicle. In the interruption waiting state, the road traffic announcement interruption can be performed by taking in the TA code obtained by demodulating the received broadcasting wave. Therefore, if the demodulation of the received broadcasting wave becomes impossible at the present received frequency of the receiver due to the deterioration of the received signal, the TA code cannot be taken in to perform the road traffic announcement interruption by the code. This applies not only to listening to the road traffic information through the interruption but also to listening to the contents of a desired program through interruption.

Specification for the radio data system for VHF/FM sound broadcasting of the European broadcasting union, 1984 discloses an RDS receiver for receiving an RDS broadcast signal carrying interruption data,
the RDS receiver having the function of performing an interruption based on the data received, and including controlling means for sweeping the received frequency of the receiver across a received frequency band when a received broadcast signal has deterioted and the receiver is in a state of waiting for the interruption, the controlling means stopping the sweep when it has become possible to obtain a data signal from another received broadcast signal when the signal is received after the starting of the sweeping.

The present invention is characterised over the above document by a lock detection circuit for generating a locking detection signal when a data signal can be obtained to indicate the received signal has not deteriorated, and generating an unlocking detection signal when no data signal can be obtained to indicate that the received broadcast signal has deteriorated.

Thus, in an RDS receiver provided in accordance with he present invention, the received frequency thereof is swept when it has become impossible to demodulate data from a received broadcast signal in a state of waiting for interruption, so that the received frequency is changed to the frequency of a RDS broadcast signal capable of being well received by the receiver. As a result, the data can be always demodulated in a stable good state of reception to obtain interruption data such as a road traffic announcement recognition code (TA code). Interruption processing based on the interruption data can thus be precisely performed. Therefore, even if the state of reception of the RDS broadcasting wave having been received by the receiver deteriorates, a desired program such as a road traffic information announcement can be heard through the interruption processing. As for road traffic announcement interruption, for example, road traffic information on an area to which a vehicle equipped with the RDS receiver is about to move can be properly heard when the vehicle has approached the boundary of the region of the network of RDS broadcasting stations or enters into the region of the next network of RDS broadcasting stations.

An embodiment of the present invention is hereafter described in detail with reference to the drawings attached hereto, in which:-
FIG. 1 shows a block diagram of an RDS receiver to which a control method which is an embodiment of the present invention is applied;
FIG. 2 shows a flow chart of the steps of the control method, which are taken by the processor of the controller of the RDs receiver;
FIG. 3 shows the base band coding structure of a radio data signal; and,
FIG. 4 shows the format of a group of a type 0 of a version A.

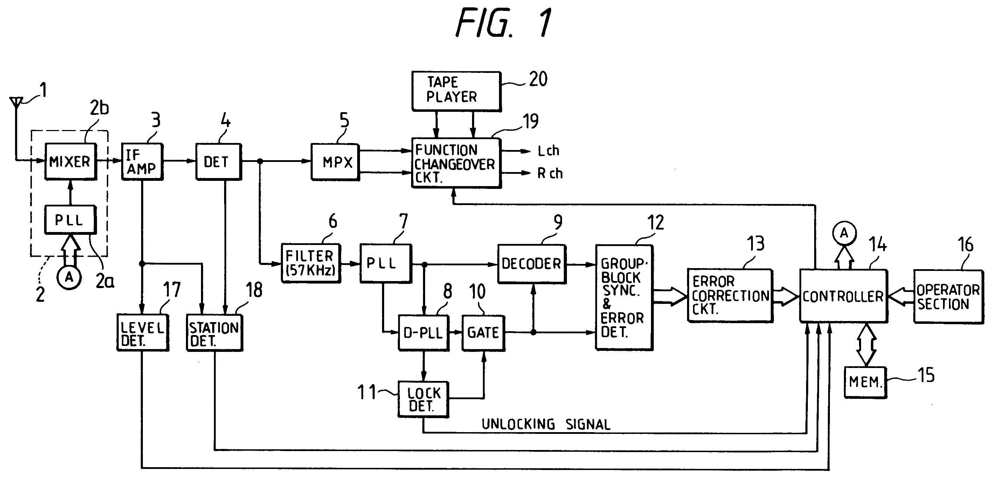

FIG. 1 shows the construction of an RDS receiver to which a control method of the embodiment is applied. A desired broadcasting station is chosen by a front end 2 from FM multiplex broadcast signals received by an antenna 1. After conversion to an intermediate frequency (IF), a signal is supplied from the front end 2 to a frequency modulation detector 4 through an IF 3. In the front end 2, a station-transmitted signal received to a mixer 2b is obtained by a PLL synthesizer system employing a PLL circuit 2a including a programmable frequency divider, the frequency division ratio of which is regulated by a controller 14 in order to enable selection of the broadcasting station. The detection output from the FM detector 4 is supplied to a multiplex demodulation circuit 5. As for stereo broadcasting, the detection output is divided into audio signals for right and left channels in the multiplex demodulation circuit 5. The output from the multiplex demodulation circuit 5 is sent out as a reproduced audio output through a function changeover circuit 19.

The function changeover circuit 19 is switched over by the controller 14 so that the circuit 19 selectively sends out the audio output from the multiplex demodulation circuit 5 or that from a tape player 20, for example.

The detection output from the FM detector 4 is passed through a filter 6 so that a radio data signal corresponding to a subcarrier wave (which is subjected to amplitude modulation by a data signal converted into biphase codes and has a frequency of 57 kHz) is extracted. The radio data signal is demodulated by a phase locked loop circuit 7, the demodulation output from which is supplied to a digital phase locked loop (D-PLL) circuit 8 and a decoder 9. In the D-PLL circuit 8, a clock signal for data modulation is generated on the basis of the demodulation output from the PLL circuit 7. The clock signal is supplied to a gate circuit 10.

When a locking detection circuit 11 has detected the locking of the D-PLL circuit 8, it generates a signal which is supplied to the gate circuit 10 to turn it on. When the D-PLL circuit 8 is unlocked because it has become impossible to demodulate data from the received broadcasting wave, the lock detection circuit 11 generates an unlocking detection signal which is supplied to the controller 14.

In the decoder 9, the data signal which is converted into the biphase codes and is the demodulation output from the PLL circuit 7 is decoded synchronously with the clock signal generated by the D-PLL circuit 8. The output data from the decoder 9 consists of groups each made up of 104 bits consisting of four 26-bit blocks as shown in FIG. 3, and is supplied to a group and block synchronization and error detection circuit 12 in which group and block synchronization is performed on the basis of 10-bit offset words allocated to the 10-bit check words of the blocks and error detection is performed as to a 16-bit information word on the basis of the check word. Data errors detected in the circuit 12 are corrected by an error correction circuit 13 and then supplied to the controller 14.

The controller 14 comprises a microcomputer so that radio data which are the codes in blocks sequentially received in the unit of a group and, such as the PI data, the AF data and the PS data are entered into the controller and stored in a memory 15. A received frequency data value for determining the frequency division ratio of the programmable frequency divider of the PLL circuit of the front end 2 is regulated by the controller 14 on the basis of a station choosing command from an operator section 16 so to choose a broadcasting station.

When the unlocking detection signal is supplied from the lock detection circuit 11 to the controller 14, the controller judges that the state of reception of a presently received broadcasting station has deteriorated to make it impossible to demodulate data.

A level detection circuit 17, by which the level (the intensity of electric field) of the signal received by the RDS receiver is found on the basis of the level of an IF signal in the IF amplifier 3, and a station detection circuit 18 are provided. When the IF signal in the IF amplifier 3 is not lower than a prescribed level and the level of the S-curve-characteristics detection output from the FM detector 4 is in a prescribed range, the station detection circuit 18 judges a broadcasting wave to be received by the receiver and sends out a station detection signal. The received signal level detection output from the level detection circuit 17 and the station detection output from the station detection circuit 18 are supplied to the controller 14.

The memory 15 comprises a non volatile random-access memory (RAM) in which data such as received frequency data, the PI code and the AF data is stored, and a read-only memory (ROM) in which a program and data are stored in advance.

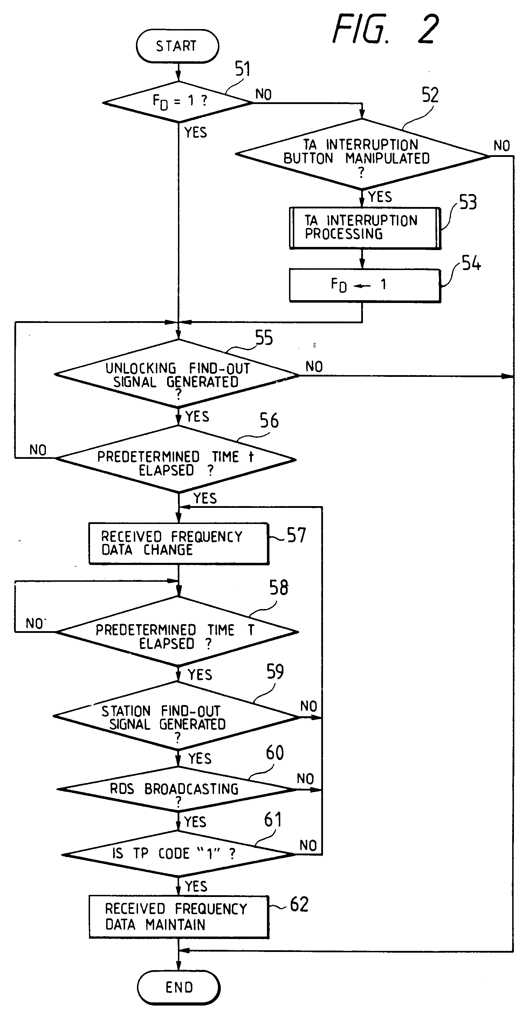

The steps of the control method, which are taken by the processor of the controller 14, are now described with reference to a flow chart shown in FIG. 2. In the first step 51, the processor judges whether or not a flag F_{D} indicative of the completion of road traffic announcement interruption wait processing is "1". If the processor has judged in the step 51 that the flag F_{D} is not "1", the processor judges in the step 52 whether or not the road traffic announcement interruption button of the operator section 16 is operated. If the processor has judged in the step 52 that the road traffic announcement interruption button is operated, the road traffic announcement interruption wait processing for controlling the function changeover circuit 19 to choose the audio signal from the tape player 20, for example, is performed by the processor in the step 53, and the flag F_{D} is then set at "1" by the processor in the step 54. After that, the processor judges in the step 55 whether or not the unlocking detection signal is generated by the lock detection circuit 11. If the processor has judged in the step 51 that the flag F_{D} is "1", the processor immediately takes the step 55.

If the processor has judged in the step 55 that the unlocking detection signal is generated by the lock detection circuit 11, the processor judges in the step 56 whether or not the generation of the signal has lasted for a prescribed time t. If the processor has judged in the step 56 that the generation of the signal has lasted for the prescribed time t, the processor judges that the state of reception of a broadcast signal by the receiver has deteriorated to make it impossible to demodulate data from the received broadcast signal, and the controller 14 then puts the receiver in a sweeping mode and changes the received frequency data value supplied from the controller to the phase loop circuit 2a, in the step 57. The processor then judges in the step 58 whether or not a prescribed time T has elapsed since the received frequency data value was changed. When the processor has judged in the step 58 that the prescribed time T has elapsed since the received frequency data value was changed, the processor judges in the step 59 whether or not the station find-out signal is generated by the station detection circuit 18. The prescribed time T is slightly longer than the time that it takes to obtain the station detection signal from a broadcast signal in the case that the wave is received by the receiver after the received frequency data value was changed.

When the received frequency data value is changed, the frequency division ratio of the frequency divider of the PLL circuit 2a is changed by a prescribed quantity so that the received frequency of the receiver is increased by 100 kHz, for example. If no broadcast signal can be received by the receiver at the increased received frequency thereof, the station detection signal is not generated. In that case, the processor takes the step 57 again so that the received frequency of the receiver is changed again. Therefore, if no broadcast signal can be received by the receiver, the received frequency thereof is changed every prescribed time T. When a broadcast signal is received by the receiver as a result of the change in the received frequency thereof, the intermediate frequency signal exceeds the prescribed level and the station detection circuit 18 generates the station detection signal if the level of the S-curve-characteristic frequency modulation detection output from the frequency modulation detector 4 is in the prescribed range. In that case, the processor judges in the step 60 whether or not the received broadcast signal is an RDS broadcast signal. When the processor has judged in the step 60 that the received broadcasting wave is an RDS broadcast signal, the error correction circuit 13 sends out data. Therefore, if the error correction circuit 13 does not send out the data, the received broadcast signal is not an RDS broadcasting wave. In that case, the processor takes the step 57 again so that the received frequency of the receiver is swept further. If the error correction circuit 13 sends out the data due to the reception of an RDS broadcasting wave, the processor judges in the step 61 whether or not the road traffic program recognition code (TF code) in the input data to the error correction circuit is "1" in logic. When the processor has judged in the step 61 that the TP code is "0" in logic, the received broadcast signal is not an RDS broadcast signal broadcasting road traffic information and the processor therefore takes the step 57 again so that the received frequency of the receiver is changed further. When the processor has judged in the step 61 that the TP code is "1" in logic, the received broadcast signal is an RDS broadcast signal broadcasting road traffic information and the present received frequency data value is therefore maintained in the step 62 so that the receiver is put out of the sweeping mode. After the receiver is put out of the sweeping mode, input data such as the program service name data (PS data) are stored into the memory 15.

When it has become impossible to demodulate the data from the received broadcast signal in the state of waiting for the road traffic announcement interruption, the RDS receiver is put in the sweeping mode so that the received frequency thereof is changed to the frequency of the RDS broadcast signal broadcasting road traffic information and capable of being well received by the receiver, as described above. As a result, the data can be always demodulated in a good state of reception so as to be accurately demodulated. The road traffic announcement interruption wait processing based on the road traffic announcement code (TA code) can thus be precisely performed to surely listen to the road traffic information through the receiver.

Although the unlocking of the D-PPL circuit 8 is detected by the lock detection circuit 11 to detect the occurrence of such a reception as to make it impossible to demodulate the data from the broadcast signal, in the above described embodiment, the present invention is not confined thereto but may be otherwise embodied so that non-synchronization in the group and block synchronization and error find-out circuit 12, the ratio of errors of data or the like is detected to detect the occurrence of such a state of reception as to make it impossible to demodulate the data from the broadcasting wave.

Although the road traffic announcement interruption based on the road traffic announcement code (TA code) is described for the above-described embodiment, the present invention is not confined thereto but may be applied to interruption based on program type data, music/speech changeover data or the like.

## Claims

1. An RDS receiver for receiving an RDS broadcast signal carrying interruption data,
the RDS receiver having the function of performing an interruption based on the data received, and including controlling means (14) for sweeping the received frequency of the receiver across a received frequency band when a received broadcast signal has deteriorated and the receiver is in a state of waiting for the interruption, the controlling means (14) stopping the sweep when it has become possible to obtain a data signal from another received broadcast signal when the signal is received after the starting of the sweeping, characterised by
a lock detection circuit (11) for generating a locking detection signal when a data signal can be obtained to indicate the received signal has not deteriorated, and generating an unlocking detection signal when no data signal can be obtained to indicate that the received broadcast signal has deteriorated.

2. An RDS receiver according to claim 1, further comprising a memory means (15) for storing the data obtained from the received broadcast signal.

3. An RDS receiver according to claim 1 or claim 2, wherein the controlling means sweeps at a frequency which is increased by predetermined frequency.

4. An RDS receiver according to any of claims 1 to 3, further comprising a station detection circuit (18) for generating a station detection signal to determine if another broadcast signal is received.

5. A method of controlling an RDS receiver capable of receiving an RDS broadcast signal carrying interruption data and which has the function of performing an interruption based on said data, including the steps of:
starting the sweeping of the received frequency of the receiver across a received frequency band when it has become impossible to obtain a data signal from a received broadcast signal in a state of waiting for the interruption; and
stopping the sweeping when it has become possible to obtain the data signal from another received broadcast signal when the data signal is received after the starting of the sweeping, characterised by:
using the output from a lock detection circuit to determine if it is still possible to obtain a data signal from the received broadcast signal or not.

6. A method according to claim 5, further comprising storing the data obtained from the received broadcast signal in a memory means (15).

7. A method according to claim 5 or claim 6, wherein the sweeping is performed at a frequency which is increased by a predetermined frequency.

## Patentansprüche

1. RDS-Empfänger zum Empfang eines RDS-Rundfunksignals, das eine Unterbrechungsinformation trägt,
wobei der RDS-Empfänger eine Unterbrechung auf der Grundlage der empfangenen Information ausführt und eine Steuereinrichtung enthält, die die Empfangsfrequenz des Empfängers über ein empfangenes Frequenzband ändert, wenn sich ein empfangenes Rundfunksignal verschlechtert hat, und sich der Empfänger in einem Bereitschaftszustand für die Unterbrechung befindet, wobei die Steuereinrichtung die Änderung unterbricht, wenn es möglich geworden ist, ein Informationssignal aus einem anderen empfangenen Rundfunksignal zu gewinnen, wenn das Signal nach dem Beginn der Änderung empfangen wird, **gekennzeichnet durch**
eine Einrast-Erfassungsschaltung, die ein Einrast-Erfassungssignal erzeugt, wenn ein Informationssignal gewonnen werden kann, um anzuzeigen, daß sich das empfangene Signal nicht verschlechtert hat, und die ein Ausrast-Erfassungssignal erzeugt, wenn kein Informationssignal gewonnen werden kann, um anzuzeigen, daß sich das empfangene Rundfunksignal verschlechtert hat.

2. RDS-Empfänger nach Anspruch 1, der des weiteren eine Speichereinrichtung (15) zum Speichern der aus dem empfangenen Rundfunksignal gewonnenen Information umfaßt.

3. RDS-Empfänger nach Anspruch 1 oder Anspruch 2, wobei die Steuereinrichtung bei einer Frequenz sucht, die um eine vorgegebene Frequenz erhöht ist.

4. RDS-Empfänger nach einem der Ansprüche 1 bis 3, der des weiteren eine Sender-Erfassungsschaltung (18) umfaßt, die ein Sender-Erfassungssignal erzeugt, um festzustellen, ob ein anderes Rundfunksignal empfangen wird.

5. Verfahren der Steuerung eines RDS-Empfängers, der in der Lage ist, ein RDS-Rundfunksignal zu empfangen, das eine Unterbrechungsinformation trägt, und-der dazu dient, eine Unterbrechung auf Grundlage der Information auszuführen, das die folgenden Schritte enthält:
Auslösen der Änderung der Empfangsfrequenz des Empfängers über ein Empfangsfrequenzband, wenn es unmöglich geworden ist, in einem Unterbrechungsbereitschaftszustand ein Informationssignal aus einem empfangenen Rundfunksignal zu gewinnen; und
Unterbrechen der Änderung, wenn es möglich geworden ist, das Informationssignal aus einem anderen empfangenen Rundfunksignal zu gewinnen, wenn das Informationssignal nach dem Beginn der Änderung empfangen wird, **gekennzeichnet durch:**
Nutzung des Ausgangs einer Einrast-Erfassungsschaltung um zu ermitteln, ob es noch möglich ist, ein Informationssignal aus dem empfangenen Rundfunksignal zu gewinnen oder nicht.

6. Verfahren nach Anspruch 5, das des weiteren das Speichern der aus dem empfangenen Rundfunksignal gewonnenen Information in einer Speichereinrichtung (15) umfaßt.

7. Verfahren nach Anspruch 5 oder Anspruch 6, wobei die Änderung bei einer Frequenz ausgeführt wird, die um eine vorgegebene Frequenz erhöht ist.

## Revendications

1. Récepteur RDS pour la réception d'un signal de radiodiffusion RDS transportant des données d'interruption, le récepteur RDS possédant une fonction d'interruption basée sur les données reçues et comprenant un moyen de commande (14) pour balayer la fréquence de réception du récepteur sur une bande de fréquences reçues lorsqu'un signal de radiodiffusion reçu est dégradé et lorsque le récepteur est dans un état d'attente d'interruption, le moyen de commande (14) arrêtant le balayage lorsqu'il devient possible d'obtenir un signal de données à partir d'un autre signal de radiodiffusion reçu lorsque le signal est reçu après le départ du balayage,
récepteur caractérisé par un circuit de détection de blocage (11) pour la génération d'un signal de détection de blocage lorsqu'un signal de données peut être obtenu pour indiquer une non dégradation du signal reçu et générant un signal de détection de déblocage lorsqu'aucun signal de données ne peut être obtenu pour indiquer que le signal de radiodiffusion reçu s'est dégradé.

2. Récepteur RDS selon la revendication 1, comprenant, de plus, un moyen de mémoire (15) pour le stockage des données obtenues à partir du signal de radiodiffusion reçu.

3. Récepteur RDS selon la revendication 1 ou 2, dans lequel le moyen de commande balaye à une fréquence augmentée d'une valeur prédéterminée.

4. Récepteur RDS selon l'une quelconque des revendications 1 à 3, comprenant, de plus, un circuit de détection de station (18) pour la génération d'un signal de détection de station afin de déterminer si un autre signal de radiodiffusion est reçu.

5. Procédé de commande d'un récepteur RDS pouvant recevoir un signal de radiodiffusion RDS transportant des données d'interruption et possédant une fonction d'interruption sur la base desdites données, procédé comprenant les étapes suivantes :
- l'amorçage du balayage de la fréquence de réception du récepteur sur une bande de fréquences reçues lorsqu'il devient impossible d'obtenir un signal de données à partir d'un signal de radiodiffusion reçu dans un état d'attente d'interruption; et
- l'arrêt du balayage lorsqu'il devient possible d'obtenir le signal de données à partir d'un autre signal de radiodiffusion reçu lorsque le signal de données est reçu après le départ du balayage;
procédé caractérisé par l'utilisation de la sortie d'un circuit de détection de blocage pour déterminer s'il est encore possible ou non d'obtenir un signal de données à partir du signal de radiodiffusion reçu.

6. Procédé selon la revendication 5, comprenant, de plus, le stockage des données obtenues à partir du signal de radiodiffusion reçu dans un moyen de mémoire (15).

7. Procédé selon la revendication 5 ou 6, selon lequel le balayage est effectué à une fréquence qui est augmentée d'une valeur prédéterminée.
